# EUROPEAN PATENT SPECIFICATION

(11) **EP 3 895 895 B1**
(45) Date of publication and mention of the grant of the patent: **12.11.2025**
(21) Application number: 21160526.6
(22) Date of filing: 03.03.2021
(51) Int. Cl.: B41F 15/20, B41F 15/08, B25B 11/00, H01L 21/683, H05K 3/12

(54) **TOOLING VACUUM UNIT**
VAKUUMEINHEIT FÜR STÜTZELEMENTE
UNITÉ D'OUTILLAGE SOUS VIDE

(30) Priority: 26.03.2020 GB 202004370
(43) Date of publication of application: 20.10.2021
(73) Proprietor: ASMPT SMT Singapore Pte. Ltd., Singapore 768924 (SG)
(72) Inventor: Foot, George Harold Bertram, Ringwood, Hampshire BH24 2QZ (GB)
(74) Representative: Emerson, Peter James

(56) References cited:
- JP-A- S63 182 893
- US-A- 4 771 234
- US-A1- 2004 108 368

## Description

This invention relates to a vacuum tooling unit, a suction nozzle, a kit of parts, a circuit board assembly machine, a tooling block and a printing machine.

### Background and Prior Art

Industrial screen-printing machines typically apply a conductive print medium, such as solder paste, silver paste or conductive ink, onto a planar workpiece, such as a circuit board, by applying the conductive print medium through a pattern of apertures in a printing screen (sometimes referred to as a mask or stencil) using an angled blade or squeegee. The same machines may also be used to print certain non-conductive media, such as glue or other adhesive, onto workpieces.

To ensure high quality printing, it is necessary to support the workpiece so that the surface to be printed is parallel to the printing screen, generally horizontal, with the workpiece support being capable of withstanding the pressure placed upon it during the printing operation, especially by the downward pressure applied by the squeegee, while maintaining the correct alignment of the workpiece. The simplest type of support is to use a flat surface or platen on which a workpiece may be placed. However, there are many circumstances where this type of arrangement is not possible, in particular where the underside of a workpiece has previously been printed and equipped with components (for example during a so-called "placement" operation), and this underside needs to be supported during a printing operation applied to the topside of the workpiece. The presence of components on the underside of the workpiece means that the workpiece will not be flat, and also the components are liable to damage if they are "squashed" during a printing operation. It will be appreciated that workpieces also need support during other processes, for example during a placement operation. To this end, specialist support solutions, known as "tooling", are used, which are typically fitted onto a flat upper surface of a support table (also known as a "tooling table"). Furthermore, in order to prevent unwanted movement of the workpiece during a print operation, it may be advantageous to apply a vacuum, partial vacuum or region of reduced atmospheric pressure (hereafter the simple term "vacuum" will be used to denote all of these arrangements) to the underside of the workpiece via the tooling to provide a clamping effect. Examples of known tooling which enable such application of vacuum include dedicated tooling blocks whose upper surface is caused, for example by machining, to have a three-dimensional profile designed to accommodate a specific PCB placed thereon, or flexible tooling which typically comprises magnetic supports such as pins, columns or walls which may be placed as required on a magnetically permeable support table, the vacuum being supplied via the support table.

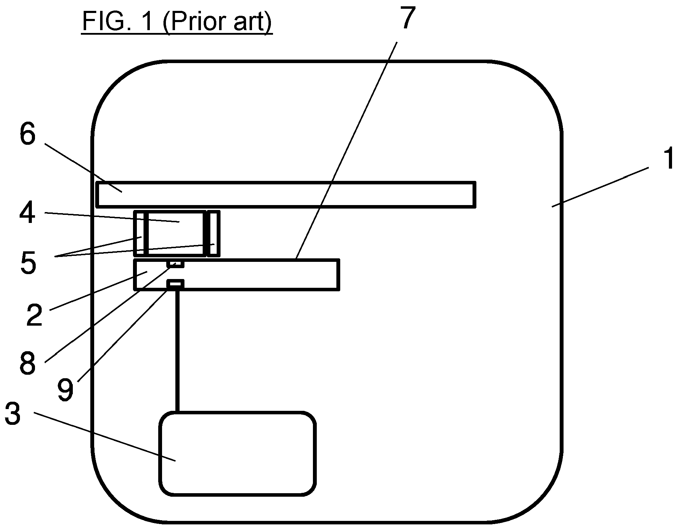

FIG. 1 schematically shows, in sectional view, a known printing machine 1 including standard vacuum tooling. In more detail, a tooling table 2 is provided within the printing machine 1, which has a magnetically permeable upper surface, hereafter referred to as the tooling support surface 7, adapted for supporting tooling 4, and which is accurately manufactured and positioned. A vacuum source 3, for example a venturi-pump or turbine pump, is connected to the tooling table 2 via a table vacuum input 9 so that at least a partial vacuum can be applied to the tooling support surface 7 of the tooling table 2, and thereby to tooling 4, to clamp a workpiece (not shown) thereon. The tooling 4 is located between rails 5, which as is known in the art may adjust to cater for workpieces of differing sizes. A printing screen 6 is held above the tooling 4 within the printing machine 1, and in use a workpiece is positioned on the tooling 4, underneath the printing screen 6, so that a squeegee (not shown), can perform a print stroke in which conductive medium is spread across the top of the printing screen 6, being forced through apertures therein and so onto the workpiece. The tooling 4 could for example comprise a dedicated tooling block, manufactured for a particular workpiece, or could for example comprise a modular magnetic system, comprising a plurality of magnetic elements selected from pins, blocks and walls, which may be positioned as required on the surface of tooling table 2 and held in position by magnetic attraction between the tooling table 2 and the component. It should be noted that the workpiece may be located in a separate carrier (not shown in FIG. 1), aiding its translation through the printing machine and the sealing to the tooling 4. It can be seen that the printing machine 1 provides an assembly volume in which a workpiece is located during an assembly operation (in this case a printing operation), with the tooling support surface 7 located at the lower extent of this assembly volume and a vacuum source 3 for applying at least a partial vacuum to the assembly volume.

With the overall trend for miniaturisation of components and circuit boards for accommodating such components, it is apparent that maximising print quality for a particular application involves providing bespoke solutions tailored for that application. It has furthermore been recognised by the present applicant that printing efficacy may be improved by similarly providing the ability to control the vacuum applied to the tooling optimised to the particular application. As used throughout this application, the terms "high vacuum" and "low vacuum" relate to the relative strength of vacuum produced by a particular vacuum source, i.e. the pressure or force which may be exerted on a board placed over a port of the vacuum source, while the terms "high flow" and "low flow" relate to the relative volume of air passing per unit time (i.e. the "mass flow rate") through such a port when connected to the vacuum source.

More particularly, it has been recognised that a vacuum created by a venturi-pump, which creates a relatively high vacuum with low flow, is highly suitable for clamping when a good seal can be guaranteed between the board and the supporting tooling, the printing screen and the tooling, and between the tooling and a carrier upon which the board may be placed, due to the relatively high vacuum achievable. However, the efficacy of a venturi-pump decreases if a good seal cannot be guaranteed, for example if leaks are present, or if the board includes cut-out sections. In such circumstances, it may be preferable to use a turbine-pump as vacuum source, which produces a relatively low vacuum but high flow, as compared to the venturi-pump. It should be understood that in many situations, it will readily be possible to predict which vacuum source would be preferable to use for a particular application.

To Applicant's knowledge, all known printing machines include only a single vacuum source for holding products.

As particular prior art may be mentioned:
JPS63182893A discloses a work stage structure with separate vacuum inputs for holding a workpiece and creating vias by sucking printing paste into through-holes in the workpiece;
US4771234 discloses a board test system with electrical connections for testing components of a supported workpiece; and
US20040108368A1 discloses a printing machine with a single vacuum sourced suction block.

It is an aim of the present invention therefore to provide a tooling solution which allows flexibility in the application of the vacuum to tooling. It is a particular aim to provide a means to selectively provide a relatively high-flow but low vacuum and / or a relatively low-flow but high vacuum to tooling. Such a means may in particular be retrofitted to an existing printing machine to provide such flexibility, although may alternatively be included within new machines. It is a further aim to make use of such means to improve a printing operation by selectively drawing the printing screen towards a workpiece using a vacuum source.

In accordance with the present invention this aim is achieved by providing a tooling vacuum unit which may be located intermediate the support table and the tooling, the tooling vacuum unit being adapted for connection to at least one vacuum source. Alternatively, the tooling vacuum unit of the present invention may be an integral or integrated part of a machine, i.e. replacing a standard support table.

As will be understood by those skilled in the art, while the present invention is described throughout with particular reference to printing machines, it is also suitable for use with other circuit board assembly machines, such as placement machines.

### Summary of the Invention

In accordance with a first aspect of the present invention there is provided a tooling vacuum unit for a circuit board assembly machine, the circuit board assembly machine having an assembly volume in which a workpiece is located during an assembly operation, and a first vacuum source for applying at least a partial vacuum to the assembly volume in use, the tooling vacuum unit comprising: a first vacuum reception port adapted for fluid communication with the first vacuum source, a first vacuum output port in fluid communication with the first vacuum reception port, a chamber having a hollow interior, a second vacuum reception port adapted for providing fluid communication between a second vacuum source in use and the hollow interior of the chamber, a second vacuum output port in fluid communication with the hollow interior of the chamber, and an upper surface adapted to receive tooling in use, the first vacuum output port and the second vacuum output port being provided at the upper surface such that in use at least a partial vacuum may be applied to the assembly volume via the second vacuum source.

In accordance with a second aspect of the present invention there is provided a suction nozzle for applying at least a partial vacuum to the underside of a component to exert a downward force to the component in use, comprising a body having a head at an upper end thereof in use, a base arranged at the lower end of the body in use, a fluid conduit within the body which opens at the head, the fluid conduit being connectable in use to a vacuum source, and a gasket at the head, the gasket providing a substantially planar sealing surface at a distal end thereof for contacting the component in use, the suction nozzle being deformable in a direction normal to the sealing surface such that the distance between the sealing surface and the base is variable upon application of a deforming force.

In accordance with a third aspect of the present invention there is provided a kit of parts comprising a tooling vacuum unit according to the first aspect and at least one suction nozzle in accordance with the second aspect.

In accordance with a fourth aspect of the present invention there is provided a circuit board assembly machine comprising an assembly volume in which a workpiece is located during an assembly operation, a first vacuum source for applying at least a partial vacuum to the assembly volume in use via a first vacuum supply port, a second vacuum source, and the tooling vacuum unit of the first aspect.

In accordance with a fifth aspect of the present invention there is provided a tooling block for supporting a workpiece within a printing machine so that during a print operation a workpiece supported thereon may be printed with print medium in a print pattern defined by a stencil, the tooling block comprising a top side which faces vertically upwards in use, the top side comprising:
a support surface for supporting a workpiece thereon in use, the support surface comprising a workpiece vacuum aperture for applying an at least partial vacuum to a workpiece supported thereon in use, and
a stencil surface arranged parallel to the support surface comprising a stencil vacuum aperture for applying an at least partial vacuum to a stencil during a printing operation.

In accordance with a sixth aspect of the present invention there is provided a printing machine comprising the tooling vacuum unit of the first aspect, fitted with the tooling block of the fifth aspect, the first vacuum output port being fluidly connected to the workpiece vacuum aperture, and the second vacuum output port being fluidly connected to the stencil vacuum aperture.

The present invention also provides a tooling block for supporting a workpiece within a printing machine, so that during a print operation a workpiece supported thereon may be printed with print medium in a print pattern defined by a stencil, the tooling block comprising:
a top side which faces vertically upwards in use, the top side comprising a first aperture and a second aperture,
a first fluid path extending between the first aperture and a first inlet port, and a second fluid path extending between the second aperture and a second inlet port, the first fluid path and the second fluid path being fluidly isolated.

Other specific aspects and features of the present invention are set out in the accompanying claims.

### Brief Description of the Drawings

The invention will now be described with reference to the accompanying drawings (not to scale), in which:
FIG. 1 schematically shows, in sectional view, a known printing machine;
FIG. 2 schematically shows, in sectional view, a printing machine retrofitted with a tooling vacuum unit in accordance with an embodiment of the present invention;
FIG. 3 schematically shows, in sectional view, a printing machine equipped with an integrated tooling vacuum unit in accordance with an embodiment of the present invention;
FIG. 4 schematically shows, in perspective view from above, the tooling vacuum unit of FIG. 2 located within a printing machine, being used to support modular magnetic tooling;
FIG. 5 schematically shows, in perspective view from above, the tooling vacuum unit of FIG. 2 located within a printing machine, being used to support dedicated tooling;
FIGs. 6 to 8 schematically show sectional views of respective tooling vacuum units in accordance with three alternative embodiments of the present invention;
FIG. 9 schematically shows, in perspective view from above, a tooling vacuum unit in accordance with an embodiment of the present invention located within a printing machine;
FIG. 10 schematically shows a sectional view of a suction nozzle in accordance with an embodiment of the present invention;
FIGs. 11 and 12 schematically show sectional views of a suction nozzle in accordance with a further embodiment of the present invention, in extended and retracted configurations respectively;
FIG. 13 schematically shows a sectional view of a suction nozzle in accordance with another embodiment of the present invention;
FIG. 14 schematically shows, in perspective view from above, a tooling vacuum unit in accordance with an embodiment of the present invention located within a printing machine;
FIG. 15 schematically shows the tooling vacuum unit of FIG. 14 while supporting a carrier;
FIG. 16 schematically shows the tooling vacuum unit of FIG. 15 while supporting a workpiece on the carrier;
FIG. 17 schematically shows a sectional side view of the tooling vacuum unit of FIG. 15;
FIG. 18 shows an exemplary timing diagram for various modes of operation;
FIG. 19 schematically shows a sectional view of a tooling block in accordance with an embodiment of the present invention during a printing operation;
FIG. 20 schematically shows the tooling block of FIG. 19 from above;
FIG. 21 schematically shows the tooling block of FIG. 20 in a perspective view from above with the external surface made transparent;
FIG. 22 schematically shows the tooling block of FIG. 19 in a perspective view from below with the external surface made transparent;
FIG. 23 schematically shows, from above, an alternative embodiment of tooling block;
FIG. 24 schematically shows a sectional view of a tooling block according to a further embodiment, in a first configuration; and
FIG. 25 schematically shows a sectional view of the tooling block of FIG. 24 in a second configuration.

### Detailed Description of the Preferred Embodiments of the Invention

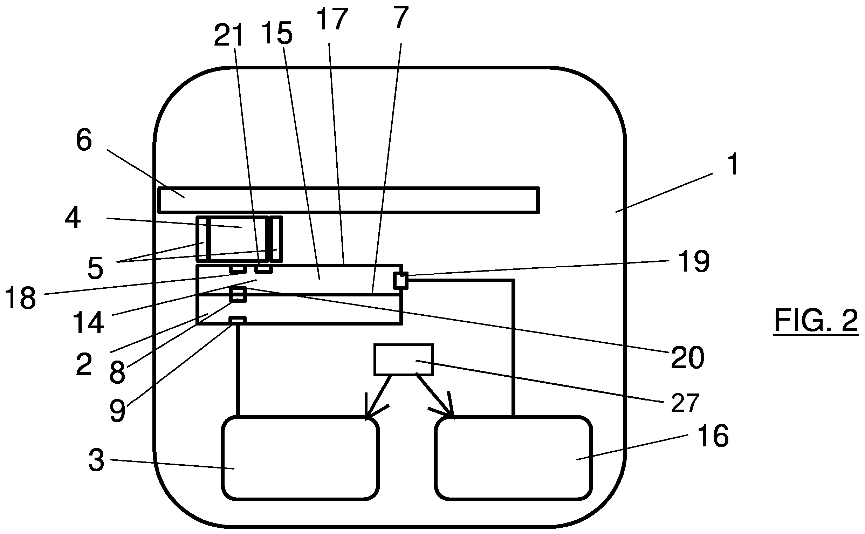

FIG. 2 schematically shows, in sectional view, the same printing machine 1 as in FIG. 1, now equipped, i.e. retrofitted, with a tooling vacuum unit 14 in accordance with an embodiment of the present invention. Since many of the elements shown in FIG. 2 are identical to those shown in FIG. 1, detailed discussion of these will be omitted. As illustrated, a tooling vacuum unit 14 is positioned onto the tooling support surface 7 of the tooling table 2, and the lower surface of the tooling vacuum unit 14 is adapted to fit onto the tooling support surface 7 so that it is accurately positioned with respect thereto. The tooling vacuum unit 14 is essentially constructed as a hollow box, defining a chamber 15 having a hollow interior. Also provided at the printing machine 1 is a second vacuum source 16, preferably of a different type to vacuum source 3 (which for clarity will hereafter be referred to as the "first vacuum source 3"). For the sake of example, the first vacuum source 3 will hereafter be considered to be a venturi-pump with the operating characteristics of a relatively high vacuum and low-flow, while the second vacuum source 16 will hereafter be considered to be a turbine-pump, with the operating characteristics of a relatively low vacuum and high-flow. The first vacuum source 3 and the second vacuum source 16 are selectively operated by a controller 27, for example a processor, computer or the like. The tooling vacuum unit 14 includes a second vacuum reception port 19, which is adapted for providing fluid communication between the second vacuum source 16 and the hollow interior of chamber 15. A second vacuum output port 21 is provided in the tooling vacuum unit 14, at the unit tooling support surface 17 in the embodiment shown, which is in fluid communication with the hollow interior of the chamber 15. In this manner at least a partial vacuum may be applied to the assembly volume via the second vacuum source 16 in use. The tooling vacuum unit 14 also comprises a first vacuum reception port 20 which is adapted for fluid communication with the first vacuum supply port 8, and a first vacuum output port 18 in fluid communication with the first vacuum reception port 20.

When located onto the tooling support surface 7, the tooling vacuum unit 14 is effectively assimilated into the tooling table, such that its upper surface, unit tooling support surface 17, provides direct support for tooling 4. To this end, the unit tooling support surface 17 is adapted to receive tooling 4 in use, and therefore includes similar features as the tooling support surface 7.

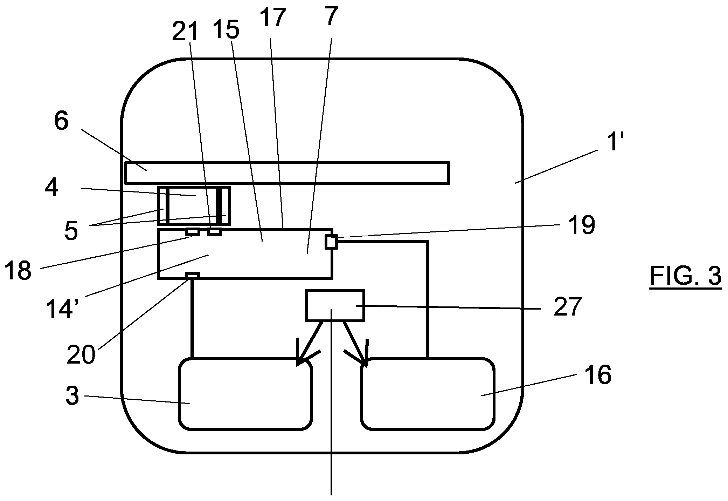

FIG. 3 schematically shows, in sectional view, a printing machine 1' equipped with an integrated tooling vacuum unit 14' in accordance with another embodiment of the present invention. In this embodiment, the tooling vacuum unit 14' is not retrofitted to a printing machine by locating on top of an existing tooling table, but instead constitutes the tooling table of the printing machine 1', i.e. it is built into the printing machine 1' as a component part, or, subsequently entirely replaces the tooling table of a printing machine 1 such as shown in FIGs. 1 or 2. The tooling vacuum unit 14' itself is very similar to the tooling vacuum unit 14 of FIG. 2, but here the first vacuum reception port 20 is adapted for direct fluid connection with the first vacuum source 3.

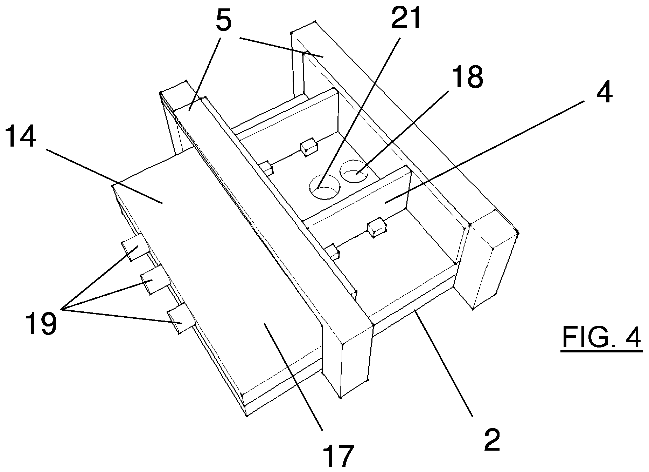

FIG. 4 schematically shows, in perspective view from above, the tooling vacuum unit 14 of FIG. 2 located within a printing machine, being used to support modular magnetic tooling 4. Like reference numerals have been retained for consistency with FIG. 2. Here, it can be seen more clearly that modular magnetic tooling 4, which as shown comprises a plurality of wall elements, is here magnetically affixed to the unit tooling support surface 17 between a pair of rails 5 to form an open box-like configuration. The first vacuum output port 18 and second vacuum output port 21 both open into the interior of this box, so that vacuum may selectively be applied thereto, either from the first vacuum source (not shown), second vacuum source (not shown), or both together, by suitable operation of the first and second vacuum sources. It can also be seen that in this embodiment the second vacuum reception port 19 actually comprises three physical ports, so that a greater total vacuum can be applied, noting that in this embodiment the second vacuum source is a relatively high-flow turbine-pump. In other embodiments, the number of ports may be chosen as required for the particular application.

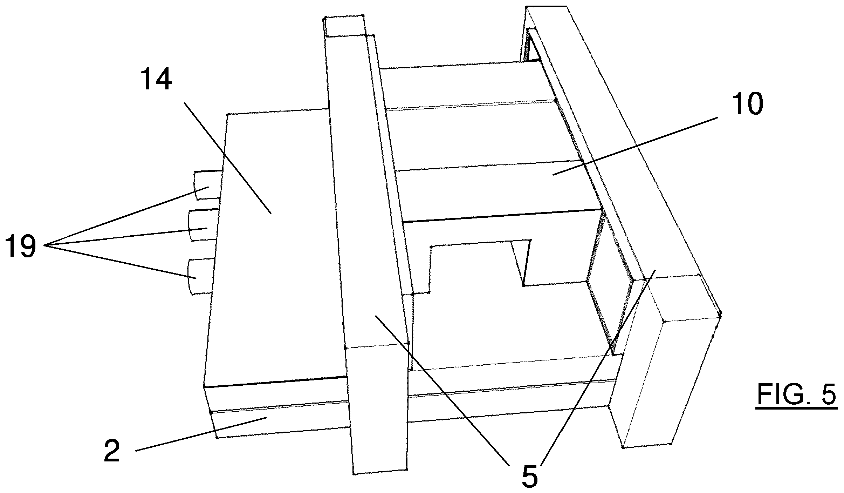

FIG. 5 schematically shows, in perspective view from above, the tooling vacuum unit 14 of FIG. 2 located within a printing machine, being used to support dedicated tooling 10. As is well-known in the art, dedicated tooling 10, such as a tooling block specifically machined to conform to a particular workpiece, may be used to support a workpiece during an assembly operation. The first vacuum output port 18 and second vacuum output port 21 (not visible in FIG. 5) both fluidly communicate with the interior of the dedicated tooling 10, so that vacuum can be applied to the underside of a supported workpiece (not shown) in use, with the vacuum being selectively applied thereto, either from the first vacuum source (not shown), second vacuum source (not shown), or both together, by suitable operation of the first and second vacuum sources.

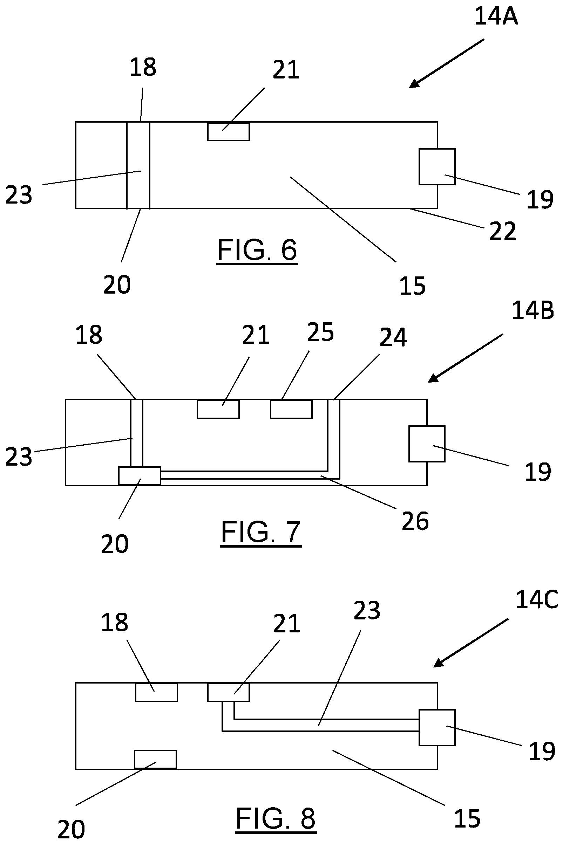

FIGs. 6 to 8 schematically show sectional views of respective tooling vacuum units in accordance with three alternative embodiments of the present invention. There are many similarities between the units, and so reference numerals will be retained for like components where possible.

FIG. 6 schematically shows a tooling vacuum unit 14A most similar to that shown in FIG. 2, having a first vacuum reception port 20 intended for connection to a venturi-pump (not shown), and a second vacuum reception port 19 intended for connection to a turbine-pump (not shown). The tooling vacuum unit 14A has a box-like construction, with outer wall 22 which surrounds and encloses chamber 15, which is hollow. In this embodiment, the first vacuum reception port 20 is fluidly connected to first vacuum output port 18 via an enclosed duct 23, so that fluid therein cannot mingle with any fluid in the chamber 15. The second vacuum reception port 19 is in fluid connection with second vacuum output port 21 via the chamber 15.

FIG. 7 schematically shows a tooling vacuum unit 14B similar to that shown in FIG. 6, having a first vacuum reception port 20 intended for connection to a venturi-pump (not shown), and a second vacuum reception port 19 intended for connection to a turbine-pump (not shown). In this embodiment, for the sake of example, the tooling vacuum unit 14B is provided with additional output ports for both the first vacuum source, i.e. additional first vacuum output port 24, and for the second vacuum source, i.e. additional second vacuum output port 25. The additional first vacuum output port 24 is fluidly connected to the first vacuum reception port 20 via an additional enclosed duct 26, such that the first vacuum reception port 20 constitutes a manifold. The additional second vacuum output port 25 is in fluid communication with the chamber 15, similarly to the second vacuum output port 21. In alternative embodiments (not shown), a larger or smaller number of output ports associated with each vacuum source may be provided, as the particular application demands. In addition, one or more of the first vacuum output ports 18, 24 or second vacuum output ports 21, 25 may be selectively closed using a removable plug (such as shown in for example) as required for the particular application.

FIG. 8 schematically shows a tooling vacuum unit 14B similar to that shown in FIG. 6, however here the first vacuum reception port 20 is intended for connection to a turbine-pump (not shown), while the second vacuum reception port 19 is intended for connection to a venturi-pump (not shown). First vacuum output port 18 is in fluid communication with the first vacuum reception port 20 via chamber 15, while second vacuum output port 21 is in fluid communication with the second vacuum reception port 19 via an enclosed duct 23. In this embodiment, for the sake of example, each of the vacuum sources is only associated with a single vacuum output port (20, 21), although additional output ports may be provided, for example in a similar manner as shown in FIG. 7.

As previously described with reference to FIG. 7, suitable design of a tooling vacuum unit can include multiple vacuum output ports, for example using a manifold in fluid communication with a vacuum reception port. This flexibility in design provides opportunities for enhanced functionality, not possible with known systems using a standard tooling table. Applicant has recognised that such designs could be used, for example, to improve contact between a printing screen and workpiece during a printing operation, by directly applying at least a partial vacuum directly to the underside of a component, in this case a printing screen, in use, to exert a downward force to the printing screen in use and draw it down onto the workpiece, and also hold it in the desired position during the print stroke.

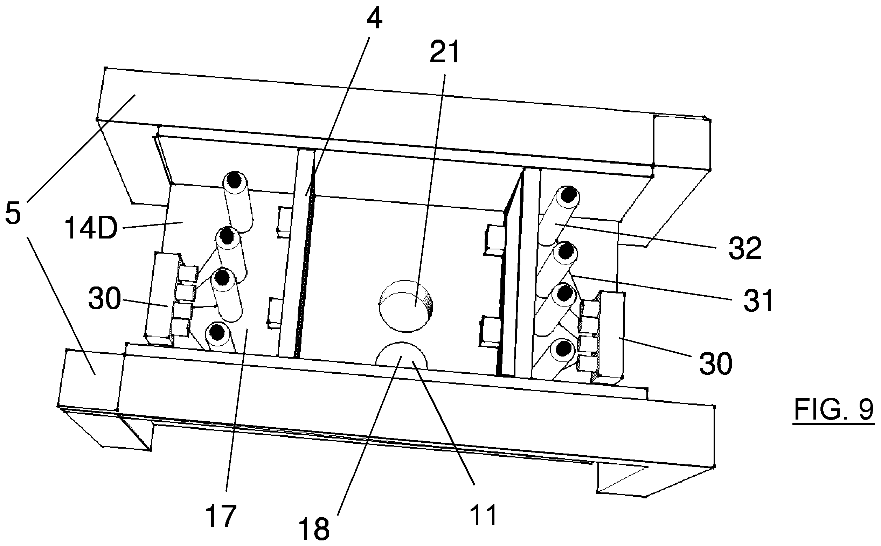

FIG. 9 schematically shows, in perspective view from above, a tooling vacuum unit 14D in accordance with an embodiment of the present invention, located within a printing machine. Here, the tooling vacuum unit 14D is used to support modular magnetic tooling 4 between rails 5, similar to the arrangement shown in FIG. 4 for example. The first vacuum source here is a venturi-pump (not shown), which, by means of enclosed ducts and an internal manifold (not shown), is fluidly connected to first and second manifolds 30, located at opposite ends of the tooling vacuum unit 14D, with the tooling 4 located therebetween. The first vacuum output port 18 is sealed off with a removable plug 11, to maximise the vacuum supplied to the first and second manifolds 30. Each manifold 30 is fluidly connected, via tubing 31, to a plurality (here four) of suction nozzles 32. Each suction nozzle 32 is held on the unit tooling support surface 17 by magnetic attraction, so it may be positioned as required. The suction nozzles 32 are of sufficient height to contact the underside of a printing screen (not shown) in use, and apply at least a partial vacuum thereto.

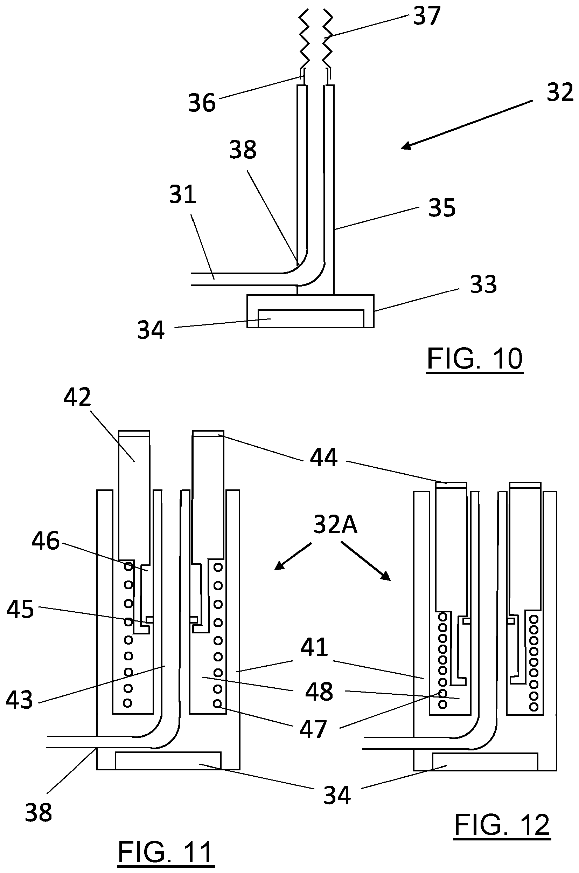

FIG. 10 schematically shows a sectional view of a suction nozzle 32 of FIG. 9. A base 33 includes a magnet 34 for releasably affixing the suction nozzle 32 to a magnetically permeable unit tooling support surface 17 of a tooling vacuum unit 14D. The base 33 carries a vertically orientated elongate body 35, which retains an end section of tubing 31, which forms a fluid conduit within the body 35. The tubing 31 exits the body 35 at a vacuum inlet 38, so that the tubing 31 may be connected to a vacuum source in use. The head or top of body 35 comprises a collar 36 which engages with a gasket in the form of bellows 37, which may be formed from a resiliently deformable material such as a plastics material. The top of bellows 37 provides a substantially planar sealing surface at a distal end thereof for contacting the printing screen in use. The bellows 37 is deformable in a downward direction, normal to the sealing surface, such that the distance between the sealing surface and the base 33 is variable upon application of a deforming force. The height of the suction nozzle 32 when the bellows is not so deformed is set to be a contact height at which the sealing surface of the suction nozzle 32 can contact the underside of a printing screen (not shown). As vacuum is applied to the top of the suction nozzle 32 via tubing 31, the printing screen is impelled downwards towards a workpiece being printed (not shown), causing the bellows 37 to deform and contract, such that the top of the suction nozzle 32 remains in contact with the printing screen for the entirety of this movement.

Other configurations of suction nozzle are possible, which still permit this deformation to occur. FIGs. 11 and 12 schematically show sectional views of a suction nozzle 32A in accordance with a further embodiment of the present invention, in extended and retracted configurations respectively. In this embodiment, a biased piston arrangement is used to enable such deformation. The body of the suction nozzle 32A comprises first and second body sections 41, 42, with the first body section 41 having an integrally formed base, which includes a magnet 34, and a fluid conduit 43 extending from a vacuum inlet 38 to the upper surface of the first body section 41 through the diametric centre thereof. An annular recess 48 surrounds the fluid conduit 43. The second body section 42 is of substantially annular form and dimensioned to be insertable within the annular recess 48 of first body section 41, around the fluid conduit 43. The upper end of the second body section comprises a gasket 44 in the form of a resiliently deformable layer, formed for example from a rubber of plastics material, which provides a substantially planar sealing surface for contacting the printing screen in use. The first and second body sections 41, 42 are relatively movable in the direction normal to the sealing surface to provide deformation of the suction nozzle 32A, which movement comprises a sliding of the second body section 42 within first body section 41. In order to delimit the range of relative movement, the first body section 41 is provided with a projection 45 projecting radially outwardly from the fluid conduit 43, which projection 45 is received within a recess 46 of the second body section 42. The range of relative movement between the first and second body sections 41, 42 is thereby delimited by abutment of the projection 45 with the upper and lower extremities of recess 46, as can be seen by comparing FIGs. 11 and 12. In order to impel the second body section 42 to an extended position, in which the distance between the sealing surface and the base is at a maximum, such as shown in FIG. 11, a biasing means, here a compression spring 47, is provided within the annular recess 48 of first body section 41, between the first and second body sections 41, 42. Those skilled in the art will appreciate that there are many alternatives ways to realise such a piston arrangement, with the system of FIGs. 11 and 12 being exemplary only.

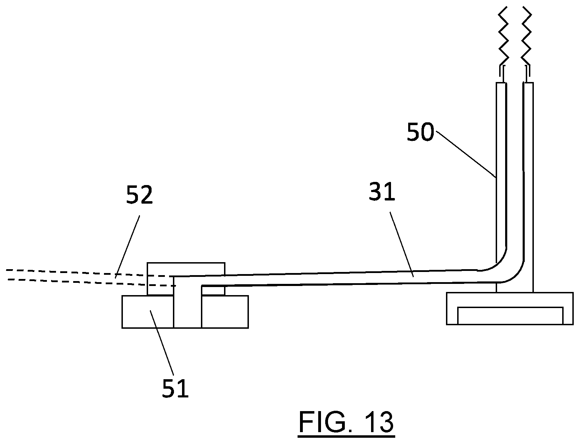

FIG. 13 schematically shows a sectional view of a suction nozzle 50 in accordance with another embodiment of the present invention. Here, the suction nozzle 32 is identical to that shown in FIG. 10. However, in contrast to the manifold arrangement shown in FIG. 9, the suction nozzle 32 here is provided with a fixture 51 adapted for direct fitting to first vacuum output port 18 of a tooling vacuum unit (such as 14, 14A, 14B or 14D). The fixture 51 provides fluid communication between the first vacuum output port 18 and the tubing 31. In alternative embodiments, additional suction nozzles 50 may be connected to a common fixture 51, for example by connecting additional tubing 52 (with one such additional tubing 52 shown in dashed lines in FIG. 12) to the fixture 51, so that the fixture 51 acts as a manifold.

As described with particular reference to FIG. 9 above, the present invention provides the ability to improve contact between a printing screen and workpiece during a printing operation, by directly applying at least a partial vacuum directly to the underside of a printing screen in use, to exert a downward force to the printing screen in use and draw it down onto the workpiece, and also hold it in the desired position during the print stroke. In a separate embodiment, a similar technique may be used to secure a different component, in this case a carrier for a workpiece, by directly applying at least a partial vacuum directly to the underside of the carrier, using at least one suction nozzle as described, for example, with reference to FIGs. 10 to 13 above.

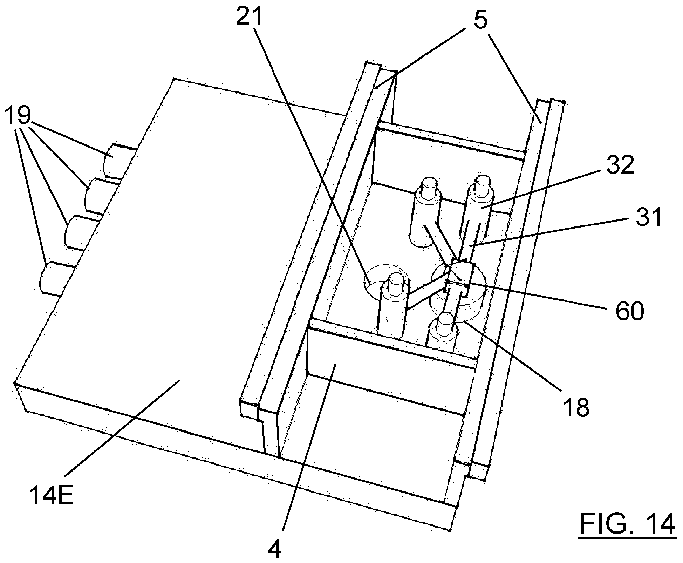

FIG. 14 schematically shows, in perspective view from above, a tooling vacuum unit 14E in accordance with an embodiment of the present invention located within a printing machine. Here, the tooling vacuum unit 14E is used to support modular magnetic tooling 4 between rails 5, similarly to the arrangement shown in FIG. 4 for example. The first vacuum source here is a venturi-pump (not shown), which is fluidly connected to the first vacuum output port 18. A turbine-pump (not shown) is used as the second vacuum source, and is fluidly connected to second vacuum output port 21 via second vacuum reception ports 19 (here, four ports are shown for the sake of example) and the interior of the tooling vacuum unit 14E. A manifold insert 60 is inserted into the first vacuum output port 18, which is connected to at least one suction nozzle 32 (with four suction nozzles 32 being shown in FIG. 14 for the sake of example) via respective tubing 31. Each suction nozzle 32 is, for the sake of example, generally similar to that shown in FIG. 10. It can be seen that, in contrast to the embodiment shown in FIG. 9, here the suction nozzles 32 are located within the tooling 4.

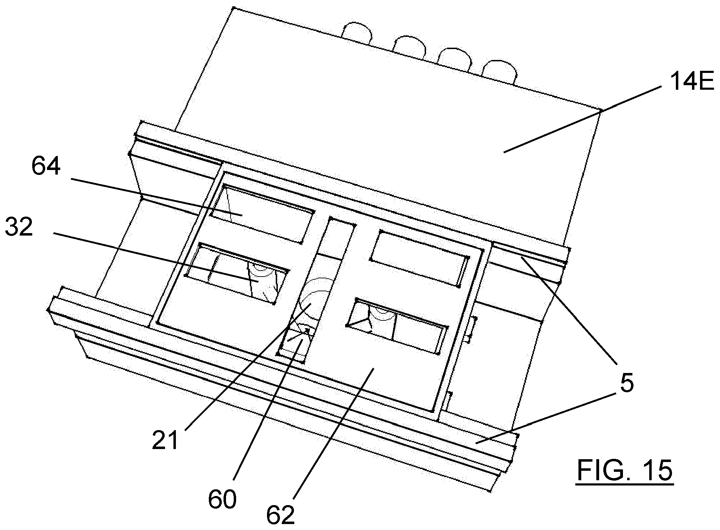

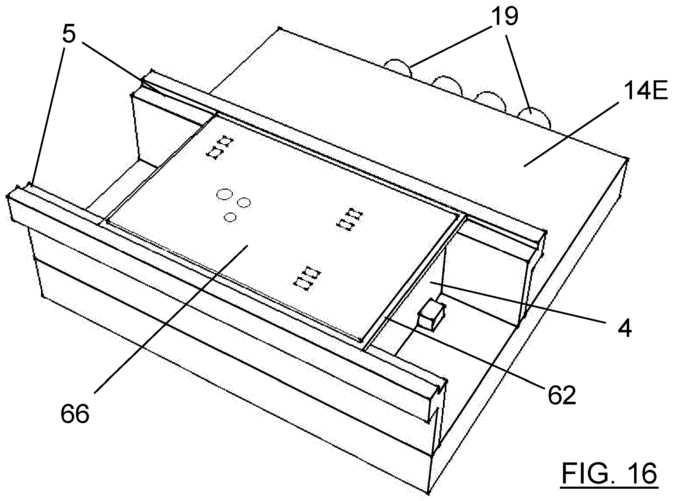

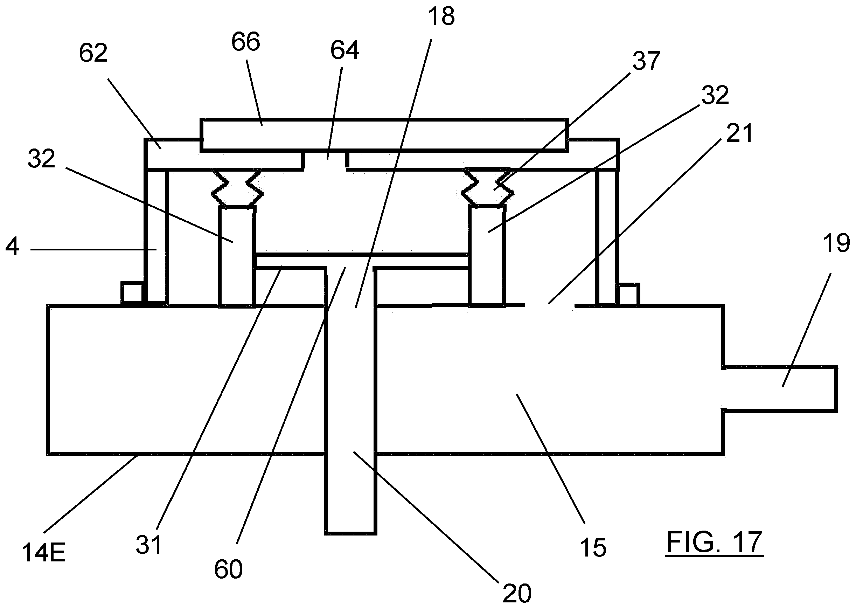

FIG. 15 schematically shows the tooling vacuum unit 14E of FIG. 14 while a carrier 62 is supported on tooling 4 and rails 5. The carrier 62 is generally formed as a tray to carry a workpiece (see FIG. 16). The carrier 62 is bespoke to the workpiece to be carried, but includes at least one aperture 64 which is open to permit fluid communication between upper and lower surfaces of the carrier 62. As can be seen in FIG. 15, the carrier 62 overlies the suction nozzles 32 and contacts bellows 37 (see FIG. 17), such that when at least a partial vacuum is applied by the suction nozzles 32, the carrier 62 is drawn down thereto and held in place by the suction nozzles 32.

FIGs. 16 and 17 schematically show the tooling vacuum unit of FIG. 15 while supporting a workpiece 66, such as a circuit board as shown, on the carrier 62. In particular, FIG. 17 shows the fluid communication pathways for both the first vacuum source and the second vacuum source. The manifold insert 60 provides an isolated fluid pathway between the first vacuum reception port 20 and the first vacuum output port 18, and hence the tubing 31 and suction nozzles 32. In use therefore, the first vacuum source is used to hold the carrier 62 via the suction nozzles 32. The second vacuum source is operable to hold the workpiece 66, since the at least partial vacuum applied thereby is in fluid communication with the underside of the workpiece 66 as shown via the second vacuum reception port 19, the chamber 15, the second vacuum output port 21, the volume within tooling 4 and apertures 64.

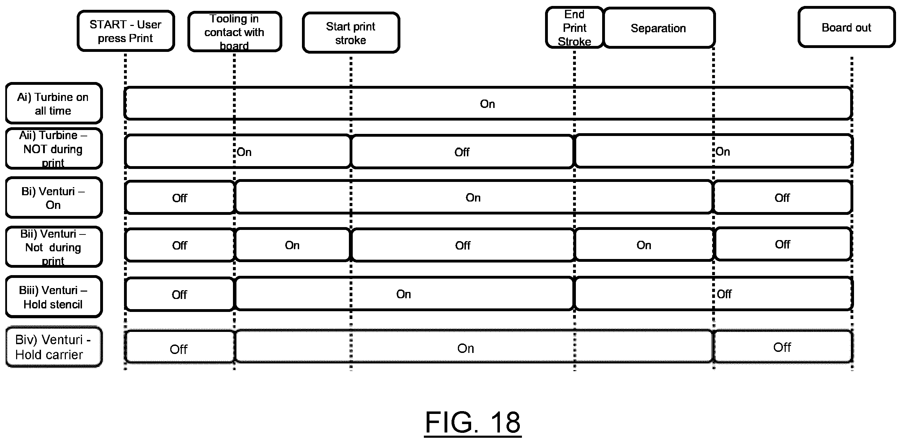

Selective operation of the connected vacuum sources provides the possibility of a wide range of vacuum timing regimes during the print operation. A schematic timing diagram illustrating five exemplary modes of operation is shown in FIG. 18, with key points of a single printing operation shown along the top, and the modes listed down the side. As shown, the printing operation commences at the "start", which could be considered as when an operator causes the operation to begin, e.g. by pressing a "Print" button on the interactive display of the printing machine controller. The board to be printed is moved into contact with the tooling, and the print stroke, in which a squeegee is used to spread conductive medium across the surface of a printing screen, can start. Following the end of the print stroke, the printing screen is separated from the board, and the printed board is moved out of the printing machine.

In the exemplary modes shown:
A) Assuming a turbine-pump or similar is provided:
   i) the print operation could be conducted with the turbine-pump on throughout the entirety of the print operation, or
   ii) the turbine could be turned off during the print stroke;
B) Assuming a venturi-pump or similar is provided:
   i) the print operation could be conducted with the venturi-pump on while the tooling is in contact with the board, but turned off at other times, or
   ii) alternatively also turned off during the print stroke, or,
   iii) if the venturi-pump is used to hold the printing screen as described previously, the venturi-pump could be turned on from the point at which the tooling contacts the board, until the completion of the print stroke, or,
   iv) if the venturi-pump is used to hold the carrier as described previously, the venturi-pump could be turned on while the tooling is in contact with the board, but turned off at other times

Of course, other modes of operation are equally possible, as will be understood by those skilled in the art.

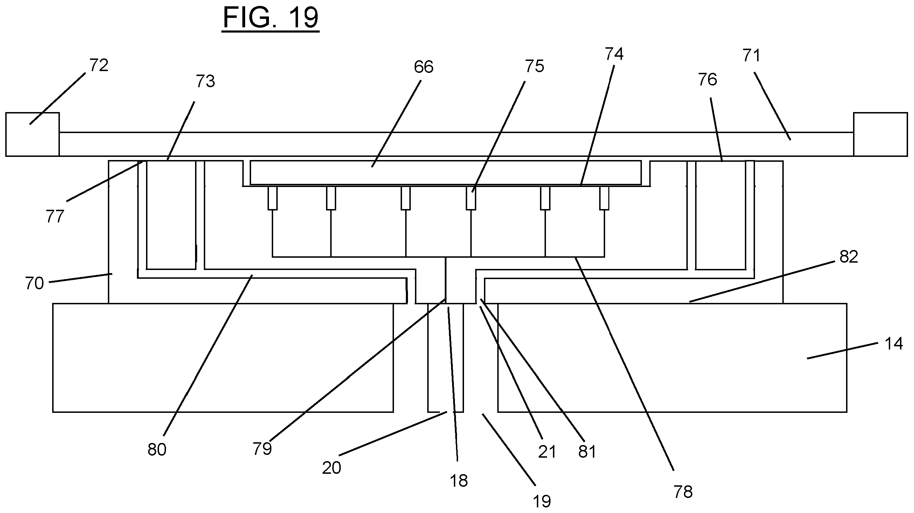

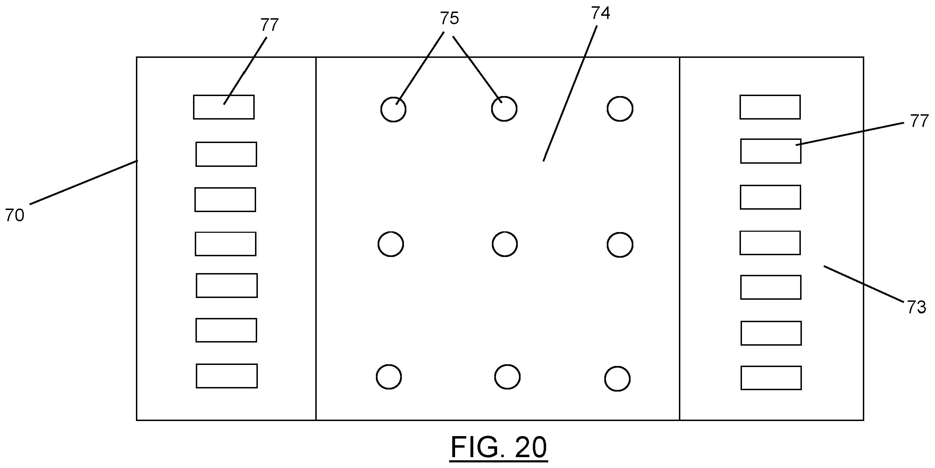

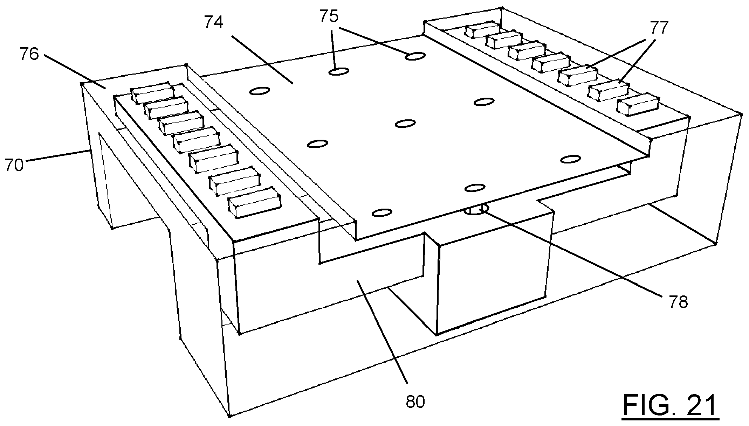

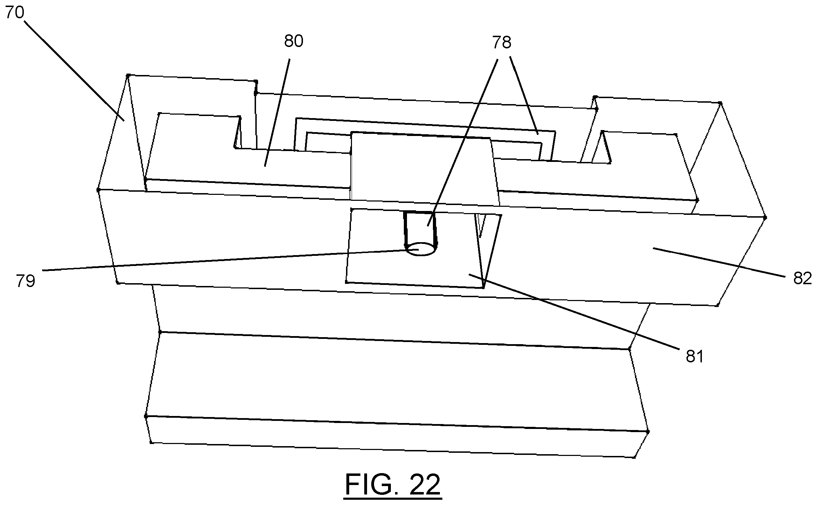

As already described, the present invention permits flexibility in the provision of vacuum within a printing machine. FIGs. 19 to 22 schematically show a tooling block 70 in accordance with a further embodiment of the present invention, which enables additional functionality over standard tooling blocks, particularly when used with the above-described tooling vacuum unit. FIG. 19 shows a sectional view of the tooling block 70 during a printing operation in which it supports a substantially planar workpiece 66 thereon, within a printing machine. FIG. 20 shows the tooling block 70 from above, FIG. 21 shows the tooling block 70 in a perspective view from above with the external surface made transparent so interior features can be seen, while FIG. 22 is similar to FIG. 21 but shows the tooling block 70 from below. During the printing operation, the workpiece 66 is printed with print medium in a print pattern defined by a stencil 71 held within a stencil tensioning frame 72. More clearly, the print pattern is defined by a pattern of apertures (not shown) formed in stencil 71 which enable print medium to pass through the stencil and be deposited on the upper surface of workpiece 66. The tooling block 70 has a top side 73 which extends over the entire width of the tooling block 70 and faces vertically upwards in use. The top side 73 includes a support surface 74 for supporting the workpiece 66 thereon. A plurality of workpiece vacuum apertures 75 are located within the support surface 74 for applying an at least partial vacuum or reduced pressure to the workpiece 66. The top side 73 also includes a stencil engagement surface 76 arranged substantially parallel to the support surface 74, which is provided with a plurality of stencil vacuum apertures 77 for applying an at least partial vacuum or reduced pressure to the stencil 71 during the printing operation. It can be seen that the support surface 74 is formed in a concavity in the top side 73, so that it is located below the stencil engagement surface 76 in use. Furthermore, the support surface 74, and hence its workpiece vacuum apertures 75, are located in a central region of the top side 73, and the stencil engagement surface 76, and hence its stencil vacuum apertures 77, is located in a boundary region of the top side 73 which is further from the centre of the top side 73 than the central region. With this configuration, the workpiece 66 sits in the concavity during the printing operation and the underside of stencil 71 can contact stencil engagement surface 76 on at least two opposing lateral "wings" of the top side 73. It should be noted that in other embodiments (not shown), the stencil engagement surface 76 could extend around three or four lateral sides of the support surface 74.

The tooling block 70 also comprises a first fluid path formed by tubing 78 extending between the workpiece vacuum aperture 75 and a first inlet port 79, and a second fluid path formed by ducting 80 extending between the stencil vacuum aperture 77 and a second inlet port 81. The first and second inlet ports 79, 81 are located at a lower side 82 of the tooling block 70. The first fluid path and the second fluid path are fluidly isolated.

It can be seen that this port arrangement enables the tooling block 70 to couple with a tooling vacuum unit 14 as previously described with reference to, for example, FIGs. 2 or 3, so that, when tooling block 70 sits on top of the tooling vacuum unit 14, the first vacuum output port 18, and hence first vacuum reception port 20, is fluidly connected to the workpiece vacuum apertures 75, and the second vacuum output port 21, and hence second vacuum reception port 19, is fluidly connected to the stencil vacuum apertures 77.

This type of tooling block 70 permits a workpiece 66 to be secured by an at least partial vacuum from a high vacuum and low flow source such as a venturi pump (not shown), while simultaneously drawing a stencil 71 down to the tooling block using an at least partial vacuum from a low vacuum and high flow source such as a turbine pump (not shown). It should be noted that if a tooling vacuum unit 14 is not used, the tooling block 70 may still be used to simultaneously secure the workpiece 66 and draw down the stencil 71 but using the same vacuum source.

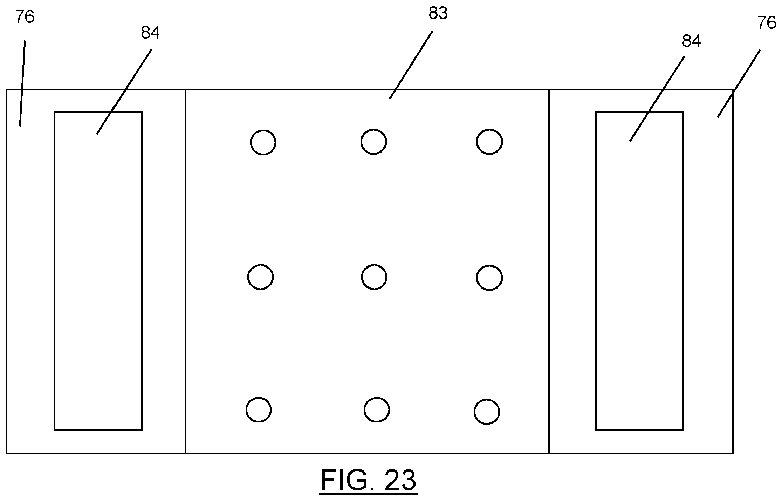

FIG. 23 schematically shows, from above, a tooling block 83, similar to that shown in FIGs. 19-22, according to an alternative embodiment in which the stencil vacuum apertures of stencil engagement surface 76 are formed by porous layers 84 received in the stencil engagement surface 76. The underside of each porous layer 84 is fluidly connected to the second fluid path (not shown), and hence the second inlet port (not shown), so that it operates in a similar manner to the tooling block 70 shown in FIGs. 19-22. Advantageously, the porous layers 84 are rigid to avoid deformation when vacuum or reduced pressure is applied via the second fluid path.

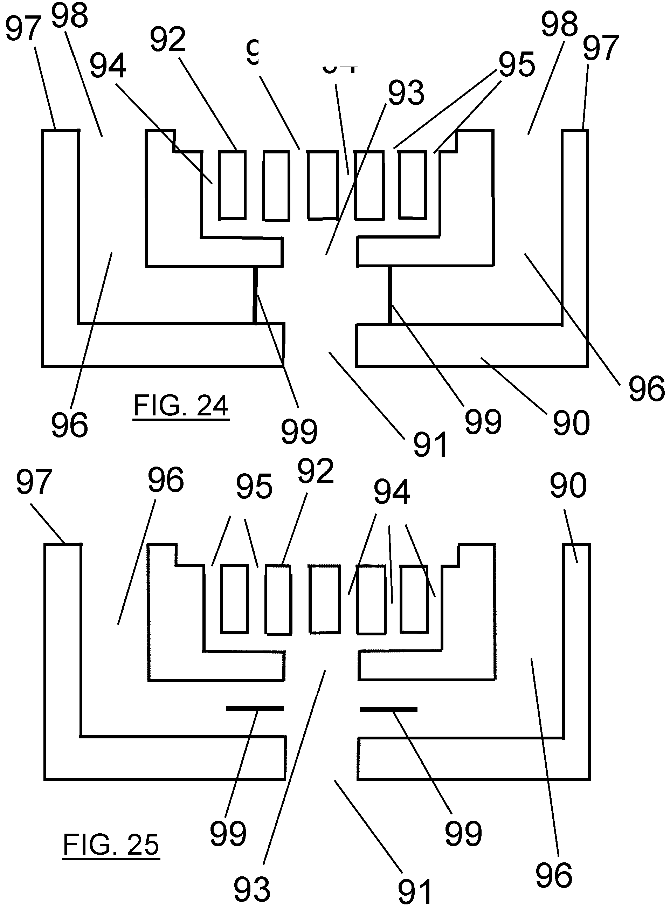

FIGs. 24 and 25 show sectional views of a tooling block 90 according to a further embodiment, which is suitable for use where only one vacuum source, for example a high-flow vacuum source (not shown), is available. A common vacuum inlet port 91 is provided, here located at the base of the tooling block 90, although it may be located as required for the particular installation. In use, the vacuum inlet port 91 is fluidly connected to the single vacuum source (not shown), so that a vacuum or reduced pressure may be applied to the vacuum inlet port 91. The vacuum inlet port 91 is fluidly connected to a support surface 92 located at a top side of the tooling block 90, via a first fluid path 93. The support surface 92 is provided to support a workpiece (not shown) thereon, and as shown is located at a central region of the tooling block 91, similarly to the embodiments shown in FIGs. 19 to 23. The first fluid path 93 includes a plurality of branches 94, each of which ends at the support surface 92 at a respective workpiece vacuum aperture 95. In this manner, when a vacuum or reduced pressure is applied by the vacuum source at the vacuum inlet 91, a vacuum or reduced pressure is provided at the support surface 92, via first fluid path 93, branches 94 and workpiece vacuum apertures 95, which acts in use to hold a workpiece (not shown) to the support surface 92. A second fluid path 96 is formed within the tooling block 91, extending between stencil vacuum apertures 98 opening at a stencil engagement surface 97, and the vacuum inlet 91. Similarly to the embodiments shown in FIGs. 19 to 22, the stencil engagement surface 97 is arranged substantially parallel to the support surface 92, and is provided with a plurality of stencil vacuum apertures 98 for applying an at least partial vacuum or reduced pressure to a stencil (not shown) during the printing operation. The support surface 92 is formed in a concavity in the top side of the tooling block 90, so that it is located below the stencil engagement surface 97 in use. Furthermore, the stencil engagement surface 97, and hence its stencil vacuum apertures 98, is located in a boundary region of the top side further from the centre of the than the support surface 92. With this configuration, a workpiece (not shown) sits in the concavity during the printing operation and the underside of the stencil can contact stencil engagement surface 97 on at least two opposing lateral "wings" of the top side. It should be noted that in other embodiments (not shown), the stencil engagement surface 97 could extend around three or four lateral sides of the support surface 92. In other embodiments, the second fluid path 96 could communicate with a porous layer similar to that shown in FIG. 23 embedded in the stencil engagement surface 97, the upper surface of which comprises the stencil vacuum apertures 98.

A valve system is provided which is controllable to selectively divert fluid flow between the first fluid path 93 and the second fluid path 96, with such control being enabled either manually by an operator, or by a control means (not shown) such as a processor, programmed computer or the like, which may advantageously also control the printing operation as is generally known in the art. As shown, the valve system comprises diverter valves 99 located in the second fluid path 96 and operable to move between a blocking position shown in FIG. 24 in which fluid flow along the second fluid path 96 is blocked, and an open position shown in FIG. 25 in which fluid flow along the second fluid path 96 is enabled. It will readily be seen that if the diverter valves 99 are in the blocking position then a vacuum or reduced pressure applied to vacuum inlet port 91 will be completely transmitted to the workpiece vacuum apertures 95, resulting in the application of a maximum workpiece holding force to an overlying workpiece and zero stencil holding force applied to an overlying stencil. When the diverter valves 99 are in the open position, the vacuum or reduced pressure will be transmitted both to the workpiece vacuum apertures 95 (resulting in the application of a workpiece holding force to an overlying workpiece less than the maximum) and to the stencil vacuum apertures 98 (resulting in a non-zero stencil holding force being applied to an overlying stencil). Advantageously, the diverter valves 99 may be controlled to lie within a full range intermediate the blocking and open positions shown, so that the ratio of workpiece holding force and stencil holding force may be selectively adjusted.

Other forms of valve system are of course possible, and will be readily envisaged by those skilled in the art.

The above-described embodiments are exemplary only, and other possibilities and alternatives within the scope of the invention will be apparent to those skilled in the art. For example, FIG. 9 shows an arrangement using suction nozzles provided outside the tooling, to engage with a printing screen, while FIG. 14 shows an arrangement in which suction nozzles are provided within the tooling. It is possible to combine these arrangements, so that suction nozzles are provided both within and outside the tooling, allowing simultaneous engagement of both a printing screen and a carrier. Either or both of the first and second vacuum sources could comprise relatively high flow sources (e.g. turbine-pumps) or either or both of the first and second vacuum sources could comprise relatively high-vacuum sources (e.g. venturi-pumps). While the invention has been described with particular reference to turbine-pumps and venturi-pumps, these are exemplary only, and any vacuum source may be used in principle. The plugs, fixtures (e.g. fixture 52) and manifold inserts described above may be fitted for engagement with either or both of the first vacuum output port and the second vacuum output port.

In respect of the above-described tooling blocks, the number of position of workpiece vacuum apertures and stencil vacuum apertures, and indeed the size and shape of the concavity formed in the top side, are all freely selectable depending on the particular application. In the extreme case, only a single workpiece vacuum aperture and stencil vacuum aperture need be provided.

### Reference numerals used:

- 1, 1' -: Printing machine
- 2 -: Tooling table
- 3 -: (First) vacuum source
- 4 -: Tooling
- 5 -: Rails
- 6 -: Printing screen
- 7 -: Tooling support surface
- 8 -: First vacuum supply port
- 9 -: Table vacuum input
- 10 -: Dedicated tooling
- 11 -: Plug
- 14, 14', 14A - 14E -: Tooling vacuum unit
- 15 -: Chamber
- 16 -: Second vacuum source
- 17 -: Unit tooling support surface
- 18 -: First vacuum output port
- 19 -: Second vacuum reception port
- 20 -: First vacuum reception port
- 21 -: Second vacuum output port
- 22 -: Outer wall
- 23 -: Enclosed duct
- 24 -: Additional first vacuum output port
- 25 -: Additional second vacuum output port
- 26 -: Additional enclosed duct
- 27 -: Controller
- 30 -: Manifold
- 31, 52 -: Tubing
- 32, 32A, 50 -: Suction nozzle
- 33 -: Base
- 34 -: Magnet
- 35 -: Body
- 36 -: Collar
- 37 -: Bellows
- 38 -: Vacuum inlet
- 41 -: First body section
- 42 -: Second body section
- 43 -: Fluid conduit
- 44 -: Gasket
- 45 -: Projection
- 46 -: Recess
- 47 -: Compression spring
- 48 -: Annular recess
- 51 -: Fixture
- 60 -: Manifold insert
- 62 -: Carrier
- 64 -: Aperture
- 66 -: Workpiece
- 70 -: Tooling block
- 71 -: Stencil
- 72 -: Stencil tensioning frame
- 73 -: Top side
- 74 -: Support surface
- 75 -: Workpiece vacuum aperture
- 76 -: Stencil engagement surface
- 77 -: Stencil vacuum aperture
- 78 -: Tubing
- 79 -: First inlet port
- 80 -: Ducting
- 81 -: Second inlet port
- 82 -: Lower side
- 83 -: Tooling block
- 84 -: Porous layer
- 90 -: Tooling block
- 91 -: Vacuum inlet port
- 92 -: Support surface
- 93 -: First fluid path
- 94 -: Branches
- 95 -: Workpiece vacuum apertures
- 96 -: Second fluid path
- 97 -: Stencil engagement surface
- 98 -: Stencil vacuum apertures
- 99 -: Diverter valves

## Claims

1. A tooling vacuum unit (14, 14', 14A - 14E) for a circuit board assembly machine (1, 1'), the circuit board assembly machine (1, 1') having an assembly volume in which a workpiece (66) is located during an assembly operation, and a first vacuum source (3) for applying at least a partial vacuum to the assembly volume in use,
the tooling vacuum unit (14, 14', 14A - 14E) comprising:
a first vacuum reception port (20) adapted for fluid communication with the first vacuum source (3), and
a first vacuum output port (18) in fluid communication with the first vacuum reception port (20),
**characterised in that** the tooling vacuum unit (14, 14', 14A - 14E) comprises:
a chamber (15) having a hollow interior,
a second vacuum reception port (19) adapted for providing fluid communication between a second vacuum source (16) in use and the hollow interior of the chamber (15),
a second vacuum output port (21) in fluid communication with the hollow interior of the chamber (15), and
an upper surface (17) adapted to receive tooling (4, 10) in use, the first vacuum output port (18) and the second vacuum output port (21) being provided at the upper surface (17),
such that in use at least a partial vacuum may be applied to the assembly volume via the second vacuum source (16).

2. The tooling vacuum unit (14, 14A, 14B, 14E) of either of claims 1 and 2, comprising a sealed fluid pathway connecting the first vacuum reception port (20) and the first vacuum output port (18), which is fluidly isolated from the hollow interior.

3. The tooling vacuum unit (14C) of claim 1, wherein the first vacuum reception port (20) and the first vacuum output port (18) are in fluid communication with the hollow interior.

4. The tooling vacuum unit of any preceding claim (14, 14', 14A - 14E), for retrofitting to a circuit board assembly machine (1, 1'), the circuit board assembly machine (1, 1') having an assembly volume in which a workpiece (66) is located during an assembly operation, a tooling support surface (2) located at the lower extent of the assembly volume and a first vacuum source (3) for applying at least a partial vacuum to the assembly volume in use via a first vacuum supply port (8) located at the tooling support surface (2),
wherein the tooling vacuum unit (14, 14', 14A - 14E) is adapted to fit onto the tooling support surface (2) in use, and the first vacuum reception port (20) is adapted for fluid communication with the first vacuum supply port (8).

5. A suction nozzle (32, 32A, 50) for applying at least a partial vacuum using a tooling vacuum unit in accordance with any of claims 1-4, to the underside of a component to exert a downward force to the component in use, comprising a body (35) having a head at an upper end thereof in use, a base (33) arranged at the lower end of the body (35, 41, 42) in use, a fluid conduit (43) within the body (35, 41, 42) which opens at the head, the fluid conduit (43) being connectable in use to a vacuum source, and a gasket (44) at the head, the gasket (37, 44) providing a substantially planar sealing surface at a distal end thereof for contacting the component in use, the suction nozzle (32, 32A, 50) being deformable in a direction normal to the sealing surface such that the distance between the sealing surface and the base (33) is variable upon application of a deforming force.

6. The suction nozzle (32, 50) of claim 5, wherein the gasket comprises bellows (37) which are deformable in the direction normal to the sealing surface.

7. The suction nozzle (32A) of claim 5, wherein the body (41, 42) comprises first (41) and second (42) body sections, which are relatively movable in the direction normal to the sealing surface to provide said deformation, optionally the suction nozzle (32A) comprises a biasing means (47) to bias the first and second body sections (41, 42) to an extended position in which the distance between the sealing surface and the base (33) is at a maximum.

8. A kit of parts comprising a tooling vacuum unit (14, 14', 14A - 14E) according to claim 4 and at least one suction nozzle (32, 32A, 50) in accordance with any of claims 5 to 7.

9. A kit of parts according to claim 8, comprising a manifold insert (60) for selectively engaging with the first vacuum output port (18) or the second vacuum output port (21).

10. A circuit board assembly machine comprising an assembly volume in which a workpiece is located during an assembly operation, a first vacuum source (3) for applying at least a partial vacuum to the assembly volume in use, a second vacuum source (16), and the tooling vacuum unit (14, 14', 14A - 14E) of any of claims 1 to 4.

11. A tooling block (70, 83, 90) for supporting a workpiece (66) within a printing machine so that during a printing operation a workpiece supported thereon may be printed with print medium in a print pattern defined by a stencil, the tooling block (70, 83, 90) comprising a top side (73) which faces vertically upwards in use, the top side (73) comprising:
a support surface (74, 92) for supporting a workpiece thereon in use, the support surface (74, 92) comprising a workpiece vacuum aperture (75, 95) for applying an at least partial vacuum using a tooling vacuum unit in accordance with any of claims 1-4, to a workpiece supported thereon in use, and
a stencil engagement surface (76, 97) arranged parallel to the support surface (74, 92) comprising a stencil vacuum aperture (77, 98) for applying an at least partial vacuum using a tooling vacuum unit in accordance with any of claims 1-4, to a stencil during a printing operation.

12. The tooling block (70, 83) of claim 11, comprising a first fluid path (78) extending between the workpiece vacuum aperture (75) and a first inlet port (79), and a second fluid path (80) extending between the stencil vacuum aperture (77) and a second inlet port (81), the first fluid path (78) and the second fluid path (80) being fluidly isolated.

13. The tooling block (90) of either of claims 11 and 12, comprising a first fluid path (93) extending between the workpiece vacuum aperture (95) and a common inlet port (91), and a second fluid path (96) extending between the stencil vacuum aperture (98) and the common inlet port (91), optionally the tooling block (90) comprises a valve system (99) controllable to selectively divert fluid flow between the first fluid path (93) and the second fluid path (96).

14. A printing machine comprising the tooling vacuum unit (14, 14', 14A - 14E) of any of claims 1 to 4, fitted with the tooling block (90) of any of claims 11 to 13, the first vacuum output port (18) being fluidly connected to the workpiece vacuum aperture (75), and the second vacuum output port (21) being fluidly connected to the stencil vacuum aperture (77).

## Patentansprüche

1. Werkzeugvakuumeinheit (14, 14', 14A - 14E) für eine Platinenmontagemaschine (1, 1'), wobei die Platinenmontagemaschine (1, 1') Folgendes aufweist: ein Montagevolumen, in dem sich ein Werkstück (66) während eines Montagevorgangs befindet, und eine erste Vakuumquelle (3) zum Anwenden von mindestens einem Teilvakuum auf das Montagevolumen in Verwendung,
die Werkzeugvakuumeinheit (14, 14', 14A - 14E) umfassend:
einen ersten Vakuumaufnahmeanschluss (20), der für eine fluidische Kommunikation mit der ersten Vakuumquelle (3) geeignet ist, und
einen ersten Vakuumausgangsanschluss (18), der in fluidischer Kommunikation mit dem ersten Vakuumaufnahmeanschluss (20) ist,
**gekennzeichnet dadurch, dass** die Werkzeugvakuumeinheit (14, 14', 14A - 14E) Folgendes umfasst:
eine Kammer (15), die einen hohlen Innenraum aufweist,
einen zweiten Vakuumaufnahmeanschluss (19), der zum Bereitstellen einer fluidischen Kommunikation zwischen einer zweiten Vakuumquelle (16) in Verwendung und dem hohlen Innenraum der Kammer (15) geeignet ist,
einen zweiten Vakuumausgangsanschluss (21), der in fluidischer Kommunikation mit dem hohlen Innenraum der Kammer (15) ist, und
eine obere Fläche (17), die dazu geeignet ist, ein Werkzeug (4, 10) in Verwendung aufzunehmen, wobei der erste Vakuumausgangsanschluss (18) und der zweite Vakuumausgangsanschluss (21) an der oberen Fläche (17) bereitgestellt sind,
sodass in Verwendung mindestens ein Teilvakuum über die zweite Vakuumquelle (16) auf das Montagevolumen angewendet werden kann.

2. Werkzeugvakuumeinheit (14, 14A, 14B, 14E) nach einem der Ansprüche 1 und 2, umfassend einen abgedichteten Fluidweg, der den ersten Vakuumaufnahmeanschluss (20) und den erste Vakuumausgangsanschluss (18) verbindet und der fluidisch von dem hohlen Innenraum isoliert ist.

3. Werkzeugvakuumeinheit (14C) nach Anspruch 1, wobei der erste Vakuumaufnahmeanschluss (20) und der erste Vakuumausgangsanschluss (18) in fluidischer Kommunikation mit dem hohlen Innenraum sind.

4. Werkzeugvakuumeinheit nach einem der vorhergehenden Ansprüche (14, 14', 14A - 14E) zum Nachrüsten in einer Platinenmontagemaschine (1, 1'), wobei die Platinenmontagemaschine (1, 1') Folgendes aufweist: ein Montagevolumen, in dem sich ein Werkstück (66) während eines Montagevorgangs befindet, eine Werkzeugtragefläche (2), die sich an der unteren Erstreckung des Montagevolumens befindet, und eine erste Vakuumquelle (3) zum Anwenden mindestens eines Teilvakuums auf das Montagevolumen in Verwendung über einen ersten Vakuumzuführanschluss (8), der sich an der Werkzeugtragefläche (2) befindet,
wobei die Werkzeugvakuumeinheit (14, 14', 14A - 14E) dazu geeignet ist, auf der Werkzeugtragefläche (2) in Verwendung installiert zu sein, und der erste Vakuumaufnahmeanschluss (20) zur fluidischen Kommunikation mit dem ersten Vakuumzuführanschluss (8) geeignet ist.

5. Saugdüse (32, 32A, 50) zum Anwenden von mindestens einem Teilvakuum unter Verwendung einer Werkzeugvakuumeinheit gemäß einem der Ansprüche 1 bis 4, auf die Unterseite einer Komponente, um eine nach unten gerichtete Kraft auf die Komponente in Verwendung auszuüben, umfassend einen Körper (35), der Folgendes aufweist: einen Kopf an einem oberen desselben in Verwendung, eine Basis (33), die an dem unteren Ende des Körpers (35, 41, 42) in Verwendung angeordnet ist, eine Fluidleitung (43) innerhalb des Körpers (35, 41, 42), die sich an dem Kopf öffnet, wobei die Fluidleitung (43) in Verwendung mit einer Vakuumquelle verbunden werden kann, und eine Dichtung (44) an dem Kopf, wobei die Dichtung (37, 44) eine im Wesentlichen planare Abdichtungsfläche an einem distalen Ende derselben zum Kontaktieren der Komponente in Verwendung bereitstellt, wobei die Saugdüse (32, 32A, 50) in einer Richtung senkrecht zu der Abdichtungsfläche verformbar ist, sodass der Abstand zwischen der Abdichtungsfläche und der Basis (33) nach Anwendung einer Verformungskraft variabel ist.

6. Saugdüse (32, 50) nach Anspruch 5, wobei die Dichtung Bälge (37) umfasst, die in der Richtung senkrecht zu der Abdichtungsfläche verformbar sind.

7. Saugdüse (32A) nach Anspruch 5, wobei der Körper (41, 42) einen ersten (41) und einen zweiten (42) Körperabschnitt umfasst, die in der Richtung senkrecht zu der Abdichtungsfläche relativ beweglich sind, um die Verformung bereitzustellen, wobei die Saugdüse (32A) optional ein Vorspannmittel (47) umfasst, um den ersten und den zweiten Körperabschnitt (41, 42) in eine erstreckte Position vorzuspannen, in der der Abstand zwischen der Abdichtungsfläche und der Basis (33) maximal ist.

8. Teilesatz, umfassend eine Werkzeugvakuumeinheit (14, 14', 14A - 14E) nach Anspruch 4 und mindestens eine Saugdüse (32, 32A, 50) gemäß einem der Ansprüche 5 bis 7.

9. Teilesatz gemäß Anspruch 8, umfassend einen Verteilereinsatz (60) zum selektiven Eingreifen in den ersten Vakuumausgangsanschluss (18) oder den zweiten Vakuumausgangsanschluss (21).

10. Platinenmontagemaschine, umfassend ein Montagevolumen, in dem sich ein Werkstück während eines Montagevorgangs befindet, eine erste Vakuumquelle (3) zum Anwenden mindestens eines Teilvakuums auf das Montagevolumen in Verwendung, eine zweite Vakuumquelle (16) und die Werkzeugvakuumeinheit (14, 14', 14A - 14E) nach einem der Ansprüche 1 bis 4.

11. Werkzeugblock (70, 83, 90) zum Tragen eines Werkstücks (66) innerhalb einer Druckmaschine, sodass während eines Druckvorgangs ein darauf getragenes Werkstück mit einem Druckmedium in einem von einer Matrize definierten Druckmuster gedruckt werden kann, wobei der Werkzeugblock (70, 83, 90) eine obere Seite (73) umfasst, die vertikal nach oben gerichtet ist, wobei die obere Seite (73) Folgendes umfasst:
eine Tragefläche (74, 92) zum Tragen eines Werkstücks darauf in Verwendung, wobei die Tragefläche (74, 92) eine Werkstückvakuumöffnung (75, 95) zum Anwenden von mindestens einem Teilvakuum unter Verwendung einer Werkzeugvakuumeinheit gemäß einem der Ansprüche 1 bis 4 auf ein darauf getragenes Werkstück in Verwendung umfasst, und
eine Matrizeneingriffsfläche (76, 97), die parallel zu der Tragefläche (74, 92) angeordnet ist, umfassend eine Matrizenvakuumöffnung (77, 98) zum Anwenden von mindestens einem Teilvakuum unter Verwendung einer Werkzeugvakuumeinheit gemäß einem der Ansprüche 1 bis 4 auf eine Matrize während eines Druckvorgangs.

12. Werkzeugblock (70, 83) nach Anspruch 11, umfassend einen ersten Fluidpfad (78), der sich zwischen der Werkstückvakuumöffnung (75) und einem ersten Eingangsanschluss (79) erstreckt, und einen zweiten Fluidpfad (80), der sich zwischen der Matrizenvakuumöffnung (77) und einem zweiten Eingangsanschluss (81) erstreckt, wobei der erste Fluidpfad (78) und der zweite Fluidpfad (80) fluidisch isoliert sind.

13. Werkzeugblock (90) nach einem der Ansprüche 11 und 12, umfassend einen ersten Fluidpfad (93), der sich zwischen der Werkstückvakuumöffnung (95) und einem gemeinsamen Eingangsanschluss (91) erstreckt, und einen zweiten Fluidpfad (96), der sich zwischen der Matrizenvakuumöffnung (98) und dem gemeinsamen Eingangsanschluss (91) erstreckt, wobei der Werkzeugblock (90) optional ein Ventilsystem (99) umfasst, das dazu steuerbar ist, einen Fluidstrom zwischen dem ersten Fluidpfad (93) und dem zweiten Fluidpfad (96) selektiv umzulenken.

14. Druckmaschine, umfassend die Werkzeugvakuumeinheit (14, 14', 14A - 14E) nach einem der Ansprüche 1 bis 4, die mit dem Werkzeugblock (90) nach einem der Ansprüche 11 bis 13 ausgerüstet ist, wobei der erste Vakuumausgangsanschluss (18) fluidisch mit der Werkzeugvakuumöffnung (75) verbunden ist, und der zweite Vakuumausgangsanschluss (21) fluidisch mit der Matrizenvakuumöffnung (77) verbunden ist.

## Revendications

1. Unité de vide d'outillage (14, 14', 14A - 14E) pour une machine d'assemblage de cartes de circuit imprimé (1, 1'), la machine d'assemblage de cartes de circuit d'imprimé (1, 1') ayant un volume d'assemblage dans lequel une pièce (66) est située pendant une opération d'assemblage, et une première source de vide (3) conçue pour appliquer au moins un vide partiel au volume d'assemblage en utilisation,
l'unité de vide d'outillage (14, 14', 14A - 14E) comprenant :
un premier orifice de réception de vide (20) adapté pour une communication fluidique avec la première source de vide (3), et
un premier orifice de sortie de vide (18) en communication fluidique avec le premier orifice de réception de vide (20),
**caractérisée en ce que** l'unité de vide d'outillage (14, 14', 14A - 14E) comprend :
une chambre (15) ayant un intérieur creux,
un deuxième orifice de réception de vide (19) adapté pour assurer une communication fluidique entre une deuxième source de vide (16) en utilisation et l'intérieur creux de la chambre (15),
un deuxième orifice de sortie de vide (21) en communication fluidique avec l'intérieur creux de la chambre (15), et
une surface supérieure (17) adaptée pour recevoir l'outillage (4, 10) en utilisation, le premier orifice de sortie de vide (18) et le deuxième orifice de sortie de vide (21) étant prévus au niveau de la surface supérieure (17),
de telle sorte qu'en utilisation au moins un vide partiel peut être appliqué au volume d'assemblage via la deuxième source de vide (16).

2. Unité de vide d'outillage (14, 14A, 14B, 14E) selon l'une ou l'autre des revendications 1 et 2, comprenant une trajectoire de fluide étanche reliant le premier orifice de réception de vide (20) et le premier orifice de sortie de vide (18), lequel est fluidiquement isolé de l'intérieur creux.

3. Unité de vide d'outillage (14C) selon la revendication 1, dans laquelle le premier orifice de réception de vide (20) et le premier orifice de sortie de vide (18) sont en communication fluidique avec l'intérieur creux.

4. Unité de vide d'outillage selon l'une quelconque des revendications précédentes (14, 14', 14A - 14E) destinée à être installée ultérieurement sur une machine d'assemblage de cartes de circuit imprimé (1, 1'), la machine d'assemblage de cartes de circuit imprimé (1, 1') ayant un volume d'assemblage dans lequel une pièce (66) est située pendant une opération d'assemblage, une surface de support d'outillage (2) située au niveau de l'étendue inférieure du volume d'assemblage et une première source de vide (3) destinée à appliquer au moins un vide partiel au volume d'assemblage en utilisation via un premier orifice de fourniture de vide (8) situé au niveau de la surface de support d'outillage (2),
dans laquelle l'unité de vide d'outillage (14, 14', 14A - 14E) est adaptée pour être installée sur la surface de support d'outillage (2) en utilisation, et le premier orifice de réception de vide (20) est adapté pour une communication fluidique avec le premier orifice de fourniture de vide (8).

5. Buse d'aspiration (32, 32A, 50) destinée à appliquer au moins un vide partiel, en utilisant une unité de vide d'outillage selon l'une quelconque des revendications 1 à 4, sur la face inférieure d'un composant pour exercer une force vers le bas sur le composant en utilisation, comprenant un corps (35) ayant une tête au niveau d'une extrémité supérieure de celui-ci en utilisation, une base (33) agencée à l'extrémité inférieure du corps (35, 41, 42) en utilisation, un conduit de fluide (43) à l'intérieur du corps (35, 41, 42) qui s'ouvre au niveau de la tête, le conduit de fluide (43) pouvant être relié en utilisation à une source de vide, et une garniture (44) au niveau de la tête, la garniture (37, 44) présentant une surface d'étanchéité sensiblement plane au niveau d'une extrémité distale de celle-ci destinée à entrer en contact avec le composant en utilisation, la buse d'aspiration (32, 32A, 50) étant déformable dans une direction normale à la surface d'étanchéité de telle sorte que la distance entre la surface d'étanchéité et la base (33) est variable lors de l'application d'une force de déformation.

6. Buse d'aspiration (32, 50) selon la revendication 5, dans laquelle la garniture comprend des soufflets (37) qui sont déformables dans la direction normale à la surface d'étanchéité.

7. Buse d'aspiration (32A) selon la revendication 5, dans laquelle le corps (41, 42) comprend des première (41) et deuxième (42) sections de corps, qui sont relativement mobiles dans la direction normale à la surface d'étanchéité pour assurer ladite déformation, la buse d'aspiration (32A) comprend éventuellement un moyen de sollicitation (47) pour solliciter les première et deuxième sections de corps (41, 42) vers une position étendue dans laquelle la distance entre la surface d'étanchéité et la base (33) est à un maximum.

8. Kit de pièces comprenant une unité de vide d'outillage (14, 14', 14A - 14E) selon la revendication 4 et au moins une buse d'aspiration (32, 32A, 50) selon l'une quelconque des revendications 5 à 7.

9. Kit de pièces selon la revendication 8, comprenant un insert collecteur (60) conçu destiné à se mettre en prise sélectivement avec le premier orifice de sortie de vide (18) ou le deuxième orifice de sortie de vide (21).

10. Machine d'assemblage de cartes de circuit imprimé comprenant un volume d'assemblage dans lequel une pièce est située pendant une opération d'assemblage, une première source de vide (3) destinée à appliquer au moins un vide partiel au volume d'assemblage en utilisation, une deuxième source de vide (16) et l'unité de vide d'outillage (14, 14', 14A - 14E) selon l'une quelconque des revendications 1 à 4.

11. Bloc d'outillage (70, 83, 90) destiné à supporter une pièce (66) à l'intérieur d'une machine d'impression de telle sorte que pendant une opération d'impression une pièce supportée sur celui-ci peut être imprimée avec un milieu d'impression selon un motif d'impression défini par un pochoir, le bloc d'outillage (70, 83, 90) comprenant une face supérieure (73) qui est orientée verticalement vers le haut en utilisation, la face supérieure (73) comprenant :
une surface de support (74, 92) destinée à supporter une pièce sur celle-ci en utilisation, la surface de support (74, 92) comprenant une ouverture de vide de pièce (75, 95) destinée à appliquer un vide au moins partiel, en utilisant une unité de vide d'outillage selon l'une quelconque des revendications 1 à 4, à une pièce supportée sur celle-ci en utilisation, et
une surface de mise en prise de pochoir (76, 97) agencée parallèlement à la surface de support (74, 92) comprenant une ouverture de vide de pochoir (77, 98) destinée à appliquer un vide au moins partiel, en utilisant une unité de vide d'outillage selon l'une quelconque des revendications 1 à 4, à un pochoir pendant une opération d'impression.

12. Bloc d'outillage (70, 83) selon la revendication 11, comprenant un premier trajet de fluide (78) s'étendant entre l'ouverture de vide de pièce (75) et un premier orifice d'entrée (79), et un deuxième trajet de fluide (80) s'étendant entre l'ouverture de vide de pochoir (77) et un deuxième orifice d'entrée (81), le premier trajet de fluide (78) et le deuxième trajet de fluide (80) étant fluidiquement isolés.

13. Bloc d'outillage (90) selon l'une ou l'autre des revendications 11 et 12, comprenant un premier trajet de fluide (93) s'étendant entre l'ouverture de vide de pièce (95) et un orifice d'entrée commun (91), et un deuxième trajet de fluide (96) s'étendant entre l'ouverture de vide de pochoir (98) et l'orifice d'entrée commun (91), le bloc d'outillage (90) comprenant éventuellement un système de vanne (99) pouvant être commandé pour dévier sélectivement le flux de fluide entre le premier trajet de fluide (93) et le deuxième trajet de fluide (96).

14. Machine d'impression comprenant l'unité de vide d'outillage (14, 14', 14A - 14E) selon l'une quelconque des revendications 1 à 4, équipée du bloc d'outillage (90) selon l'une quelconque des revendications 11 à 13, le premier orifice de sortie de vide (18) étant relié fluidiquement à l'ouverture de vide de la pièce (75), et le deuxième orifice de sortie de vide (21) étant relié fluidiquement à l'ouverture de vide du pochoir (77).
